# EUROPEAN PATENT APPLICATION

(11) **EP 4 753 440 A1**
(43) Date of publication of application: **03.06.2026**
(21) Application number: 25214625.3
(22) Date of filing: 10.11.2025
(51) Int. Cl.: H10W 90/20, H10W 74/01, H10W 90/00

(54) **GALVANICALLY ISOLATED COMMUNICATION LINKS (GICL) PACKAGE STRUCTURE WITH INTEGRATED ISOLATION AS PART OF DIE**

(30) Priority: 29.11.2024 CN 202411745109
(71) Applicant: NXP USA, Inc., Austin, TX 78735 (US)
(72) Inventor: Ge, You, 5656AG Eindhoven (NL); Wang, Zhijie, 5656AG Eindhoven (NL); Lee, Yit Meng, 5656AG Eindhoven (NL); Shah, Ankur Shailesh, 5656AG Eindhoven (NL); Wu, Xueting, 5656AG Eindhoven (NL)
(74) Representative: Colaiuda, Antonella

(57) **Abstract**

Aspects of the subject disclosure may include, for example, a packaged integrated circuit device that includes two galvanically isolated integrated circuit die. The integrated circuit die include conductive coils that can be inductively coupled for wireless communications between the two galvanically isolated integrated circuit die. A first integrated circuit die is mounted to a lead frame and a second integrated circuit die is surrounded by a molding compound structure and an insulating layer. The second integrated circuit is adhered to the first integrated circuit in a manner that aligns the conductive coils and provides galvanic isolation between the two integrated circuit die. Other embodiments are disclosed.

## Description

### FIELD OF THE DISCLOSURE

The subject disclosure relates to integrated circuit package structures.

### BACKGROUND

Galvanically isolated integrated circuits may communicate wirelessly. For example, two galvanically isolated integrated circuit die may each have conductive coils that can be used to communicate through inductive coupling.

### SUMMARY

In an example embodiment, a system includes a first integrated circuit die with a first communication coil; a second integrated circuit die with a second communication coil, wherein the second integrated circuit die is positioned with respect to the first integrated circuit die such that the first communication coil is aligned with the second communication coil to allow inductive coupling between the first communication coil and the second communication coil; a molding compound structure positioned about a perimeter of the second integrated circuit die; and an insulating layer positioned between the first integrated circuit die and the second integrated circuit die, and positioned between the first integrated circuit die and the molding compound structure.

Additional example embodiments of the system include the insulating layer comprising a polymer layer formed on a backside of the second integrated circuit die and the molding compound structure, and the insulating layer comprising a polyimide layer. Further example embodiments include the molding compound structure covering a backside of the second integrated circuit die, and the insulating layer comprising a polymer layer formed on the molding compound structure. Further example embodiments include the first integrated circuit die and the second integrated circuit die being in separate voltage domains, and the insulating layer providing galvanic isolation between the first integrated circuit die and the second integrated circuit die, a dielectric adhesive layer between the first integrated circuit die and the insulating layer, and the first integrated circuit die including at least a third communication coil and the second integrated circuit die including at least a fourth communication coil.

In another example embodiment, a packaged integrated circuit device includes a first integrated circuit die having a first conductive coil, and a first bond pad to provide a first electrical connection to the first integrated circuit die; a second integrated circuit die having a second conductive coil for inductive coupling to the first conductive coil, and a second bond pad to provide a second electrical connection to the second integrated circuit die, the second integrated circuit die being surrounded on at least four sides by a molding compound structure; and a dielectric layer positioned on a backside of the second integrated circuit die and the molding compound structure, wherein the dielectric layer is positioned between the first integrated circuit die and the second integrated circuit die.

Additional example embodiments of the packaged integrated circuit device may include the dielectric layer comprising a polymer layer, such as a polyimide layer spun on the backside of the second integrated circuit die and the molding compound structure, and an adhesive layer between the dielectric layer and the first integrated circuit die. Additional example embodiments include the dielectric layer providing galvanic isolation between the first integrated circuit die and the second integrated circuit die, wherein the first bond pad and the second bond pad are galvanically isolated from each other.

In another example embodiment, a method may include forming a first conductive coil on a first integrated circuit die; forming a second conductive coil on a second integrated circuit die; back grinding the second integrated circuit die; forming a molding compound structure on at least four sides of the second integrated circuit die; grinding the molding compound structure to expose a backside of the second integrated circuit die; forming an insulating layer on the backside of the second integrated circuit die and the molding compound structure; and coupling the second integrated circuit die to the first integrated circuit die such that the second conductive coil aligns with the first conductive coil to allow inductive coupling between the first conductive coil and the second conductive coil, and such that insulating layer provides galvanic isolation between the first integrated circuit die and the second integrated circuit die.

Additional example embodiments of the method include wherein the forming the insulating layer comprises forming a polyimide layer on the backside of the second integrated circuit die and the molding compound structure, and wherein the coupling the second integrated circuit die to the first integrated circuit die comprises applying an adhesive to the first integrated circuit die and placing the second integrated circuit die on the adhesive. Additional example embodiments of the method include wherein the insulating layer provides galvanic isolation between the first integrated circuit die and the second integrated circuit die; wherein the first integrated circuit die and the second integrated circuit die are in separate voltage domains, and the insulating layer provides galvanic isolation between the first integrated circuit die and the second integrated circuit die; forming at least a third communication coil on the first integrated circuit die; and forming at least a fourth communication coil on the second integrated circuit die.

### BRIEF DESCRIPTION OF THE DRAWINGS

The present disclosure is illustrated by way of examples, embodiments, and the like and is not limited by the accompanying figures, in which like reference numbers indicate similar elements. Elements in the figures are illustrated for simplicity and clarity and have not necessarily been drawn to scale. The figures along with the detailed description are incorporated and form part of the specification and serve to further illustrate examples, embodiments and the like, and explain various principles and advantages, in accordance with the present disclosure, wherein:
FIGs. 1 and 2 are cross-sectional illustrations of packaged electronic devices that include two galvanically isolated integrated circuit devices;
FIGs. 3A and 3B show an example process flow in accordance with various embodiments; and
FIG. 4 is a flowchart representing example methods in accordance with various embodiments.

### DETAILED DESCRIPTION

The following detailed description provides examples for the purposes of understanding and is not intended to limit the invention or the application and uses of the same. Furthermore, there is no intention to be bound by any expressed or implied theory presented in the preceding technical field, background, or the following detailed description.

For simplicity and clarity of illustration, the drawing figures illustrate the general manner of construction, and descriptions and details of well-known features and techniques may be omitted to avoid unnecessarily obscuring the invention. Additionally, elements in the drawing figures are not necessarily drawn to scale. For example, the dimensions of some of the elements or regions in the figures may be exaggerated relative to other elements or regions to help improve understanding of embodiments of the invention.

The terms "first," "second," "third," "fourth" and the like in the description and the claims, if any, may be used for distinguishing between similar elements and not necessarily for describing a particular sequential or chronological order. It is to be understood that the terms so used are interchangeable under appropriate circumstances such that the embodiments of the invention described herein are, for example, capable of operation in sequences other than those illustrated or otherwise described herein. Furthermore, the terms "comprise," "include," "have" and any variations thereof, are intended to cover non-exclusive inclusions, such that a process, method, article, or apparatus that comprises a list of elements is not necessarily limited to those elements but may include other elements not expressly listed or inherent to such process, method, article, or apparatus. The term "coupled," as used herein, is defined as directly or indirectly connected in an electrical or non-electrical manner. As used herein the terms "substantial" and "substantially" mean sufficient to accomplish the stated purpose in a practical manner and that minor imperfections, if any, are not significant for the stated purpose.

Directional references such as "top," "bottom," "left," "right," "above," "below," and so forth, unless otherwise stated, are not intended to require any preferred orientation and are made with reference to the orientation of the corresponding figure or figures for purposes of illustration.

It will be appreciated that the steps of various processes described herein are nonlimiting examples of suitable processes according to embodiments and are for the purposes of illustration. Systems and devices according to embodiments herein may be use any suitable processes including those that omit steps described above, perform those steps and similar steps in different orders, and the like. It will also be appreciated that well-known features may be omitted for clarity.

Unless explicitly stated otherwise, the use of terms "approximately," "substantially" and similar terms in connection with dimensions, relative positioning, or orientation of various features indicates that the dimensions, positioning, or orientation of those features are subject to tolerances and/or expected process variations of equipment and processes chosen to form the described features. Unless explicitly stated otherwise, the use of terms "approximately," "substantially" and similar terms in connection with measurable values or characteristics is subject to the expected measurement accuracy of equipment and methods used to measure those values or characteristics and/or within tolerance limits specified by technical standards applicable to the technologies described.

Communication between galvanically isolated integrated circuit die can be achieved by inductively coupling conductive communication coils in the integrated circuit die. This type of communication is referred to herein as Galvanically Isolated Communication Links (GICL). The size of the coils (and/or an amount of signal power) used for GICL may be influenced by the distance between the coils. For example, for a given signal power, a larger distance between inductively coupled coils will result in larger coils, which in turn may cause increases in overall integrated circuit die sizes.

Various embodiments described herein improve signal transfer by reducing distance between coils in integrated circuit die while maintaining galvanic isolation thereby allowing the reduction of coil size and potentially reducing integrated circuit die area. A stacked combination of two integrated circuit die includes a top die with an insulating material that acting as an insulation layer between the two die configured to provide the required amount of DC voltage isolation between the two die. The top die is background to reduce thickness, and coils in the two integrated circuit die are separated by the thickness of the top die and the thickness of the insulation layer and any adhesive. These and other embodiments are further described below.

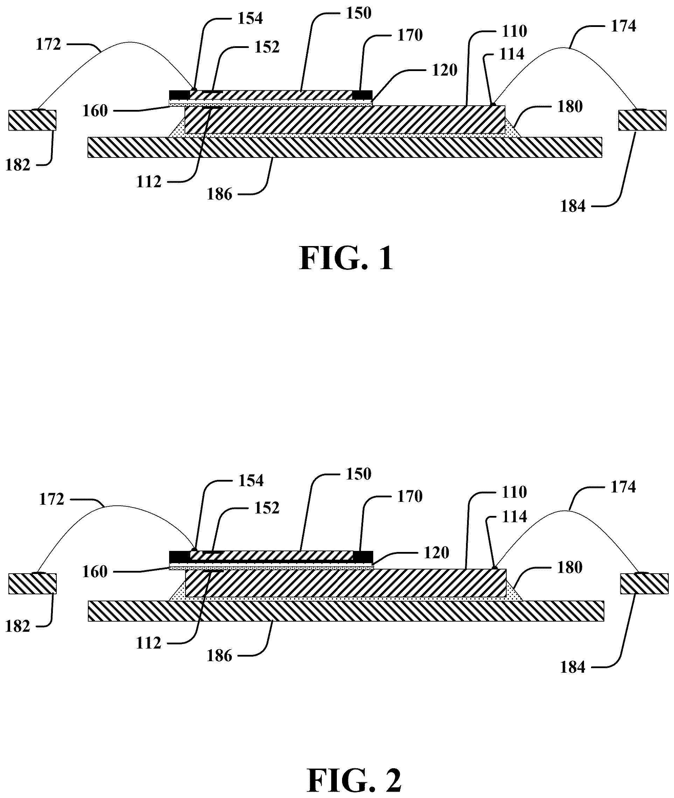

FIG. 1 is a cross-sectional illustration of a packaged electronic device that includes two galvanically isolated integrated circuit devices. The packaged electronic device of FIG. 1 includes a first integrated circuit die 110 and a second integrated circuit die 150 separated by an insulating layer 120. In some embodiments, the insulating layer 120 has a high voltage breakdown characteristic (e.g., the insulating layer 120 can withstand a voltage >5000 Volts without breaking down) such that the two integrated circuit die can operate in different voltage domains and can withstand large voltage transients without damaging either integrated circuit die. As an example, and not by way of limitation, one integrated circuit die may include digital control circuitry operating at a relatively low voltage (e.g., less than 10 Volts), and the second integrated circuit die may include high voltage circuitry (e.g., operating at hundreds of Volts) intended to drive an inverter or a motor (e.g., for an electric vehicle).

As shown in FIG. 1, the first integrated circuit die 110 is mounted to a lead frame segment 186. The first integrated circuit die 110 includes one or more conductive coils 112 and at least one bond pad 114 formed thereon. In some embodiments, the conductive coil(s) 112 and bond pad 114 are formed on one or more metallization layer(s) on the first integrated circuit die 110. In the example of FIG.1, the bond pad 114 provides power to the first integrated circuit die 110. In some embodiments, the bond pad 114 may provide a signal connection to the first integrated circuit die 110. Bond pads formed on integrated circuit die 110 may be used for any combination of signal connections and power connections. In the example of FIG. 1, wire 174 is wire bonded to bond pad 114 and lead frame segment 184. One conductive coil 112 is shown on integrated circuit die 110; however, any number of conductive coils may be included. Similarly, one bond pad 114 is shown on integrated circuit die 110; however, any number of bond pads may be included.

In some embodiments, conductive coil(s) 112 are electrically coupled to wireless communication circuits within integrated circuit die 110. For example, one or more of conductive coil(s) 112 may be coupled to transmitter circuits, receiver circuits, transceiver circuits, or the like. In some embodiments, bond pad 114 may be electrically coupled to one or more circuits nodes within integrated circuit die 110 that supply power to circuits within integrated circuit die 110. In these embodiments, when a voltage is applied to bond pad 114, power may be supplied to circuits within integrated circuit die 110 such as control circuits, transmitter circuits, receiver circuits, transceiver circuits, or the like.

The second integrated circuit die 150 includes one or more conductive coils 152 and one or more bond pads 154 formed thereon. In some embodiments, the conductive coil 152 and bond pad 154 are formed on a metallization layer on the second integrated circuit die 150. In the example of FIG.1, the bond pad(s) 154 may provide signal and power connections to the second integrated circuit die 150. For example, a first bond pad 154 may provide power to the second integrated circuit die 150 and a second bond pad 156 may provide other signal routing for integrated circuit die 150. In the example of FIG. 1, wire 172 is wire bonded to bond pad 154 and lead frame segment 182. One conductive coil 152 is shown on integrated circuit die 150; however, any number of conductive coils may be included. Similarly, one bond pad 154 is shown on integrated circuit die 150; however, any number of bond pads may be included.

In some embodiments, conductive coil(s) 152 are electrically coupled to wireless communication circuits within integrated circuit die 150. For example, one or more of conductive coil(s) 152 may be coupled to transmitter circuits, receiver circuits, transceiver circuits, or the like. In some embodiments, bond pad 154 may be electrically coupled to one or more circuits nodes within integrated circuit die 150 that supply power to circuits within integrated circuit die 150. In these embodiments, when a voltage is applied to bond pad 154, power may be supplied to circuits within integrated circuit die 150 such as control circuits, transmitter circuits, receiver circuits, transceiver circuits, or the like.

Insulating layer 120 may include any material (at any thickness) that provides the desired amount of dielectric insulation qualities (e.g., >5000V breakdown characteristic). For example, a passivation layer (e.g., a polymer such as polyimide) may be formed on the back side of integrated circuit die 150 at a thickness that provides the desired characteristics.

Second integrated circuit die 150 has a molding compound structure 170 on at least four sides. In some embodiments, the back side of the second integrated circuit die 150 is polished or ground (also referred to herein as "backgrinding") until the second integrated circuit die 150 is a desired thickness, and then the molding compound is formed about the second integrated circuit die 150. The insulating layer 120 is formed on the backside of the second integrated circuit die 150 and the molding compound structure 170. These processes and related processes are described further below.

The second integrated circuit die 150 with the molding compound structure 170 and insulating layer 120 is mounted to first integrated circuit die 110 in a manner that substantially vertically aligns conductive coil(s) 152 with conductive coil(s) 112. In some embodiments, this is performed using a nonconductive adhesive 160. In some embodiments, second integrated circuit die 150 extends beyond a footprint of first integrated circuit die 110 as shown in FIG. 1, where second integrated circuit die 150 extends further to left of the footprint of first integrated circuit die 110. In other embodiments, second integrated circuit die 150 is adhered to first integrated circuit die 110 within the footprint of first integrated circuit die 110.

In embodiments represented by FIG. 1, insulating layer 120 is positioned between the first integrated circuit die 110 and the second integrated circuit die 150, and is also positioned between the first integrated circuit die 110 and the molding compound structure 170. The distance between inductively coupled conductive coils 152 and 112 is reduced as compared to an implementation in which second integrated circuit die 150 is not ground and/or has a thicker insulating layer 120. If the second integrated circuit die 150 were not ground to reduce thickness, and/or the insulating layer were a thicker layer, the distance between the inductively coupled conductive coils would be increased. In the various embodiments described herein, the inductively coupled conductive coils are brought closer together, potentially allowing for lower signal power, smaller conductive coils, smaller integrated circuit die, or any combination thereof.

FIG. 2 is a cross-sectional illustration of a packaged electronic device that includes two galvanically isolated integrated circuit devices. In embodiments represented by

FIG. 2, molding compound structure 170 surrounds the second integrated circuit 150 on five sides. In these embodiments, insulating layer 120 is positioned between the first integrated circuit die 110 and the second integrated circuit die 150, and is also positioned between the first integrated circuit die 110 and the molding compound structure 170. In some embodiments, this is accomplished by backgrinding the second integrated circuit die 150, forming molding compound structure 170 on second integrated circuit die 150 including on the backside, forming insulating layer 120 on the molding compound structure 170, and adhering second integrated circuit die 150 to first integrated circuit die 110 in a manner that aligns conductive communication coils 112 and 152 to allow for inductive coupling between the coils.

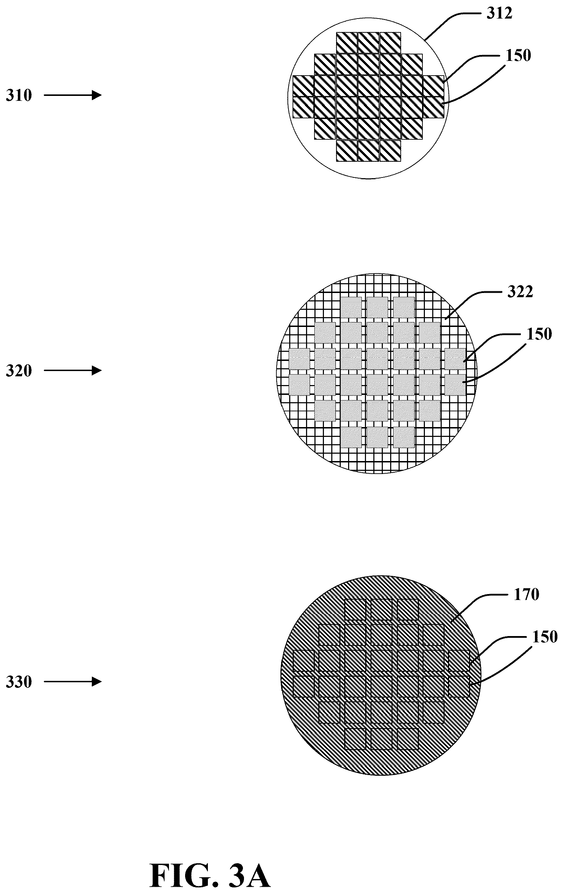

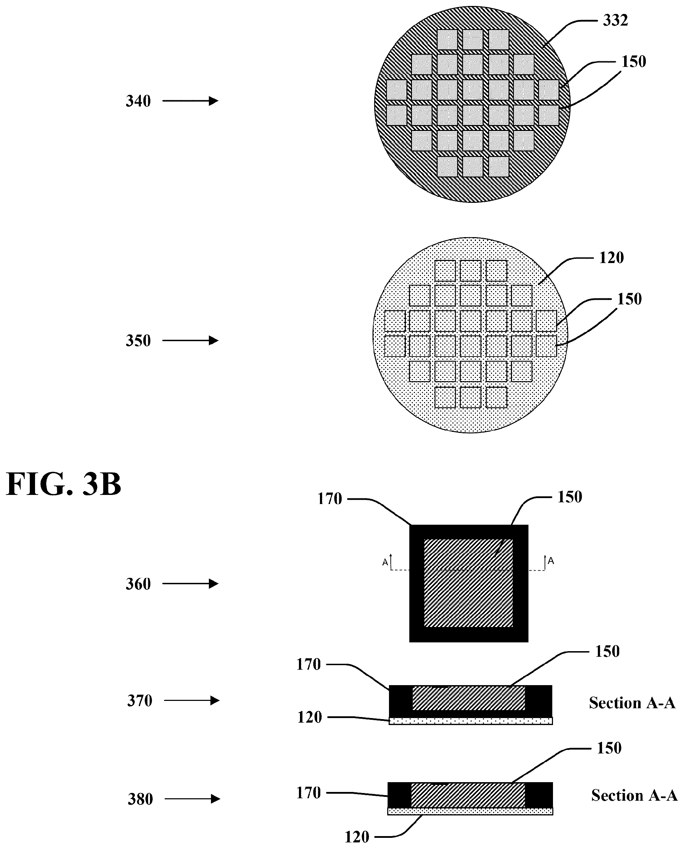

FIGs. 3A and 3B show an example process flow in accordance with various embodiments. At 310, a wafer 312 includes multiple second integrated circuit die 150. The integrated circuit die 150 shown at 310 already have conductive communication coils 152 and bond pads 154 formed thereon. Further, at 310, the back side of the wafer 312 is ground to a desired thickness. For example, in some embodiments, the wafer may be ground to a thickness of ~75um. The integrated circuit die 150 may then be singulated.

At 320, the singulated integrated circuit die are placed onto a substrate 322 (e.g., a tape) with the backside exposed. The distance(s) between the die 150 may be determined using any mechanism or criteria, including for example, an internal creepage requirement. In some embodiments as an example, the distance between the die 150 on substrate 322 may be about 120-300um.

At 330, a molding compound 170 is formed on the tape 322 and die 150 to form a reconstituted wafer. The molding compound 170 covers the four sides of each die 150 and also covers the backside of the die 150. At 340, the molding compound 170 is ground. In some embodiments, the molding compound 170 is ground enough to expose the backsides of the die 150. In other embodiments, the molding compound 170 is ground to create a uniform surface, but not enough to expose the backsides of the die 150. In still further embodiments, the actions of 340 are skipped, and the molding compound is not ground at all. After the actions of 340, the reconstituted wafer may include die 150 with molding compound 170 on four sides, or die 150 with molding compound on five sides (e.g., four sides plus the backside).

At 350, an insulating layer 120 is formed on the reconstituted wafer. In some embodiments, a polymer layer is formed on the reconstituted wafer to form insulating layer 120. In some embodiments, insulating layer 120 is made of a dielectric material that is thick enough to provide a desired minimum voltage breakdown characteristic (e.g., >5000V). For example, insulating layer 120 may be formed by a polyimide layer with a desired thickness (e.g., ~20um). In some embodiments, the insulating layer 120 may be in contact with molding compound 170 along with the backsides of the die 150 (e.g., when the molding compound is on four sides of die 150), and in other embodiments, the insulating layer 120 may be in contact with only the molding compound 170 (e.g., when the molding compound is on five sides of die 150). The die 150 and surrounding molding compound may then be singulated.

A top view of the singulated die is shown at 360. The singulated die includes integrated circuit die 150, molding compound structure 170, and insulating layer 120. In some embodiments, as shown in Section A-A at 370, the insulating layer 120 is only in contact with the molding compound structure 170. This may be accomplished by not back grinding the molding compound at 340, or by leaving some molding compound covering the back side of dies 150 at 340. In other embodiments, as shown in Section A-A at 380, the insulating layer 120 is in contact with the molding compound structure 170 and the backside of the integrated circuit die 150.

The operations described with reference to FIGs. 3A and 3B prepare second integrated circuit die 150 along with molding compound structure 170 and insulating layer 120 to be combined with first integrated circuit die 110 to form the packaged integrated circuit device shown in FIG. 1 and/or FIG. 2. In some embodiments, the second integrated circuit die 150 along with molding compound structure 170 and insulating layer 120 are affixed to integrated circuit die 110 in a manner that aligns the conductive communication coils to allow inductive coupling between the coils. This may be accomplished with a nonconductive or dielectric adhesive by applying the adhesive to first integrated circuit die 110 and placing the singulated die structure shown at 370 or 380 in the adhesive with the insulating layer 120 between the first integrated circuit die 110 and the second integrated circuit die 150, and between the first integrated circuit die110 and the molding compound structure 170.

The resulting packaged integrated circuit device (see FIGs. 1, 2) includes a first integrated circuit die 110 with a first communication coil 112; a second integrated circuit die 150 with a second communication coil 152, wherein the second integrated circuit die 150 is positioned with respect to the first integrated circuit die 110 such that the first communication coil 112 is aligned with the second communication coil 152 to allow inductive coupling between the first communication coil 112 and the second communication coil152; a molding compound structure 170 positioned about a perimeter (e.g., on four sides) of the second integrated circuit die 150 ; and an insulating layer 120 positioned between the first integrated circuit die 110 and the second integrated circuit die 150, and positioned between the first integrated circuit die 110 and the molding compound structure 170.

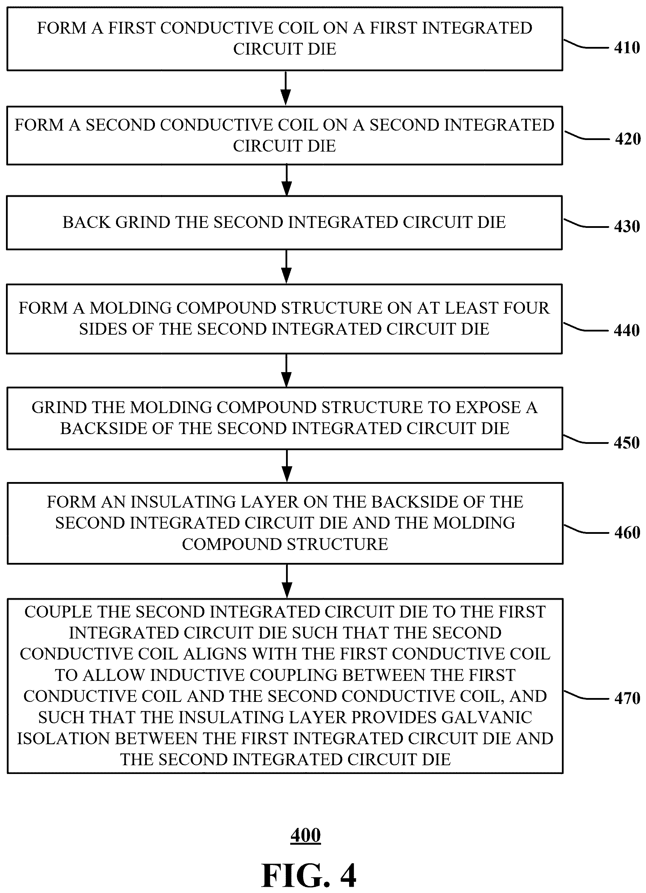

FIG. 4 is a flowchart representing example methods in accordance with various embodiments. At 410, a first conductive coil is formed on a first integrated circuit die. The first conductive coil may be a communication coil for use in inductive coupling to a coil in another integrated circuit die that is galvanically isolated from the first integrated die. For example, the actions of 410 may form conductive coil(s) 112 on integrated circuit die 110.

At 420, a second conductive coil is formed on a second integrated circuit die. The second conductive coil may be a communication coil for use in inductive coupling to a coil in another integrated circuit die that is galvanically isolated from the second integrated die. For example, the actions of 420 may form conductive coil(s) 152 on integrated circuit die 150.

At 430, the backside of the second integrated circuit die is ground. In some embodiments, this includes back grinding a wafer that includes multiple of the second integrated circuit die. For example, as described above with reference to 310 in FIG. 3A, the back side of wafer 312 may be ground to result in multiple second integrated circuit die 150 of a desired thickness. The wafer may then be singulated to produce individual singulated integrated circuit die 150 that are then placed on a substrate such as a tape as described above with reference to 320 in FIG. 3A.

At 440, a molding compound structure is formed on at least four sides of the second integrated circuit die. In some embodiments, this includes forming a molding compound over the integrated circuit die 150 on the substrate to create a reconstituted wafer as described above with reference to 330 in FIG. 3A. At 450, the molding compound structure is ground to expose a backside of the second integrated circuit die. For example, the molding compound structure may be ground as described above with reference to 340 in FIG. 3B so that the molding compound is left around the perimeter (e.g., on four sides) of the second integrated die but not on the backside of the second integrated circuit die. In other embodiments, the molding compound structure on the backside of the second integrated circuit die may not be completely ground away such that the molding compound is left around the perimeter of the second integrated die and also on the backside of the second integrated circuit die (e.g., on five sides). In still further embodiments, the actions of 450 are omitted and the molding compound structure is not ground at all.

At 460, an insulating layer is formed on the backside of the second integrated circuit die and the molding compound structure. In some embodiments, the insulating layer is a passivation layer formed from a polymer. The insulating layer may insulate the second integrated circuit die from the first integrated circuit die to provide galvanic isolation between the integrated circuit die while providing wireless communication between conductive coils in the integrated circuit die through inductive coupling. In some embodiments, the insulating layer is formed on a combination of the backside of the second integrated circuit die and the molding compound structure as shown at 380 in FIG. 3B and in the packaged integrated circuit device in FIG. 1. In other embodiments, the insulating layer is formed on the molding compound structure as shown at 370 in FIG. 3B and in the packaged integrated circuit device in FIG. 2.

Additionally, the first integrated circuit die may be mounted on a lead frame. In some embodiments, this includes mounting on a lead frame having electrically isolated lead frame segments. For example, the first integrated circuit die may be mounted on a first lead frame segment that is isolated from second and third lead frame segments (e.g., lead frame segments 182, 184).

At 470, the second integrated circuit die is coupled to the first integrated circuit die such that the second conductive coil aligns with the first conductive coil to allow inductive coupling, and such that the insulating layer provides galvanic isolation between the first integrated circuit die and the second integrated circuit die.

## Claims

1. A system, comprising:
a first integrated circuit die with a first communication coil;
a second integrated circuit die with a second communication coil, wherein the second integrated circuit die is positioned with respect to the first integrated circuit die such that the first communication coil is aligned with the second communication coil to allow inductive coupling between the first communication coil and the second communication coil;
a molding compound structure positioned about a perimeter of the second integrated circuit die; and
an insulating layer positioned between the first integrated circuit die and the second integrated circuit die, and positioned between the first integrated circuit die and the molding compound structure.

2. The system of claim 1, wherein the insulating layer comprises a polymer layer formed on a backside of the second integrated circuit die and the molding compound structure.

3. The system of claim 1 or claim 2, wherein the insulating layer comprises a polyimide layer or material with similar properties.

4. The system according to any preceding claim, wherein the molding compound structure covers a backside of the second integrated circuit die.

5. The system of claim 4, wherein the insulating layer comprises a polymer layer formed on the molding compound structure.

6. The system according to any preceding claim , wherein the first integrated circuit die and the second integrated circuit die are in separate voltage domains, and the insulating layer provides galvanic isolation between the first integrated circuit die and the second integrated circuit die.

7. The system according to any preceding claim, further comprising a dielectric adhesive layer between the first integrated circuit die and the insulating layer.

8. The system according to any preceding claim, wherein the first integrated circuit die includes at least a third communication coil and the second integrated circuit die includes at least a fourth communication coil.

9. A method, comprising:
forming a first conductive coil on a first integrated circuit die;
forming a second conductive coil on a second integrated circuit die;
back grinding the second integrated circuit die;
forming a molding compound structure on at least four sides of the second integrated circuit die;
grinding the molding compound structure to expose a backside of the second integrated circuit die;
forming an insulating layer on the backside of the second integrated circuit die and the molding compound structure; and
coupling the second integrated circuit die to the first integrated circuit die such that the second conductive coil aligns with the first conductive coil to allow inductive coupling between the first conductive coil and the second conductive coil, and such that the insulating layer provides galvanic isolation between the first integrated circuit die and the second integrated circuit die.

10. The method according to claim 9, wherein the forming the insulating layer comprises forming a polyimide layer on the backside of the second integrated circuit die and the molding compound structure.

11. The method according to any of claims 9 to 10, wherein the coupling the second integrated circuit die to the first integrated circuit die comprises:
applying an adhesive to the first integrated circuit die; and
placing the second integrated circuit die in the adhesive.

12. The method according to any of claims 9 to 11, wherein the insulating layer provides galvanic isolation between the first integrated circuit die and the second integrated circuit die.

13. The method according to any of claims 9 to 12, wherein the first integrated circuit die and the second integrated circuit die are in separate voltage domains, and the insulating layer provides galvanic isolation between the first integrated circuit die and the second integrated circuit die.

14. The method according to any of claims 9 to 13, further comprising:
forming at least a third communication coil on the first integrated circuit die; and
forming at least a fourth communication coil on the second integrated circuit die.
